Europäisches Patentamt

(19) European Patent Office

Office européen des brevets

(11) Veröffentlichungsnummer: **0 021 218**
**B1**

(12) # EUROPÄISCHE PATENTSCHRIFT

(45) Veröffentlichungstag der Patentschrift:
20.07.83

(21) Anmeldenummer: 80103198.0

(22) Anmeldetag: 09.06.80

(51) Int. Cl.³: **G 11 C 11/24**, **H 01 L 27/10**,
**H 01 L 29/78**, **H 01 L 21/265**,
**H 01 L 21/82**

(54) **Dynamische Halbleiter-Speicherzelle und Verfahren zu ihrer Herstellung.**

(30) Priorität: **29.06.79 DE 2926417**

(43) Veröffentlichungstag der Anmeldung:
**07.01.81 Patentblatt 81/1**

(45) Bekanntmachung des Hinweises auf die Patenterteilung:
**20.07.83 Patentblatt 83/29**

(84) Benannte Vertragsstaaten:
**FR GB**

(56) Entgegenhaltungen:
**DE-A-2 754 066**
**FR-A-2 379 168**
**US-A-4 143 388**

**PATENT ABSTRACTS OF JAPAN, Band 2, Nr. 55, 21. April 1978, Seite 1261E78**

**TECHNICAL DIGEST, 1977, International Electron Devices Meeting, 5.–7. Dezember 1977, Seiten 399–401 Washington D.C., U.S.A. J. TIHANYI et al.: «Dimos — A novel IC technology with submicron effective channel Mosfets»**

(73) Patentinhaber: **SIEMENS AKTIENGESELLSCHAFT, Berlin und München Wittelsbacherplatz 2, D-8000 München 2 (DE)**

(72) Erfinder: **Tihanyi, Jenö, Dr., Wolfratshauser Strasse 179b, D-8000 München 71 (DE)**

**IBM TECHNICAL DISCLOSURE BULLETIN, Band 21, Nr. 1, Juni 1978, Seiten 190–193 R.T. DENNISON: «Dynamic random-access memory with read-only memory characteristics at power-on time»**

**IBM TECHNICAL DISCLOSURE BULLETIN, Band 21, Nr. 9, Februar 1979, Seiten 3823–3825 New York, U.S.A. V.L. RIDEOUT: «Double polysilicon dynamic random-access memory cell with increased charge storage capacitance»**

## Dynamische Halbleiter-Speicherzelle und Verfahren zu ihrer Herstellung

Die Erfindung bezieht sich auf eine dynamische Halbleiter-Speicherzelle nach dem Oberbegriff des Patentanspruchs 1 und auf Verfahren zu ihrer Herstellung.

Speicherzellen dieser Art sind beispielsweise in der US-PS 3 533 089 beschrieben.

Aus dem «Technical Digest 1977, International Electron Devices Meeting», 5. bis 7. Dezember 1977, Washington D.C., Seiten 399 bis 401, sind MOS-Feldeffekttransistoren mit sehr kurzen effektiven Kanallängen bekannt, bei denen jeweils ein Gate isoliert auf einer Grenzfläche eines Halbleiterkörpers aufgebracht ist und zwei entgegengesetzt zum Halbleiterkörper dotierte Gebiete so in diesen eingefügt sind, dass sie beiderseits des Gate an der Grenzfläche des Halbleiterkörpers liegen. Unterhalb eines dieser Gebiete (Sourcegebiet) ist eine weitere Halbleiterzone vorgesehen, die parallel zur Grenzfläche verläuft und einen höheren Dotierungsgrad als der Halbleiterkörper aufweist, aber denselben Leitungstyp wie dieser besitzt. Ein unterhalb des Gate liegender Randbereich der weiteren Halbleiterzone erstreckt sich bis zur Grenzfläche hin, so dass er dieses eine Gebiet (Sourcegebiet) in lateraler Richtung begrenzt. Weiterhin ist unterhalb des Gate ein der Grenzfläche benachbarter, den Randbereich der weiteren Halbleiterzone mit dem anderen Gebiet verbindender Bereich des Halbleiterkörpers vorgesehen, der zu diesem entgegengesetzt dotiert ist. Der an der Grenzfläche liegende Teil des Randbereiches bildet einen einteiligen Kanalbereich des Transistors. Die Ausbildung eines solchen Transistors als Transistor mit einem zweiteiligen Kanalbereich und sein Ersatz als ein Teil einer Halbleiter-Speicherzelle ist dieser Veröffentlichung jedoch nicht zu entnehmen.

Zur Erzielung immer grösserer Integrationsdichten strebt man in der Halbleiter-Speichertechnik an, die einzelnen Speicherzellen auf einer möglichst kleinen Halbleiterfläche zu plazieren. Erfindungsgemäss wird diese Aufgabe bei einer Speicherzelle der eingangs genannten Art durch die im kennzeichnenden Teil des Patentanspruchs 1 angegebenen Massnahmen gelöst.

Der mit der Erfindung erzielbare Vorteil besteht insbesondere darin, dass die Zellenstruktur eine wesentlich kleinere Halbleiterfläche für den Feldeffekttransistor erfordert, als dies bei den herkömmlichen Ein-Transistor-Speicherzellen der Fall ist. Das ist darauf zurückzuführen, dass das Gate des Feldeffekttransistors mit technologisch bedingten Mindestabmessungen ausgeführt werden kann, wobei der von diesem überdeckte Transistorkanal eine noch wesentlich kleinere Länge aufweist. Der Feldeffekttransistor ist daher bezüglich seiner Einsatzspannung von Schwankungen der Substratvorspannung weitgehend unabhängig. Weiterhin ist die auf eine vorgegebene Halbleiterfläche bezogene Kapazität des Speicherkondensators grösser als bei den herkömmlichen Speicherzellen. Bei der im Anspruch 2 angegebenen Weiterbildung der Erfindung fällt diese Kapazitätserhöhung noch mehr ins Gewicht. Die Ansprüche 3 bis 8 sind auf vorteilhafte Ausführungsformen der Erfindung gerichtet, wobei die Ausführungen nach den Ansprüchen 5 und 6 sehr kleine Bitleitungskapazitäten gewährleisten. Besonders günstige Herstellungsverfahren für die erfindungsgemässe Speicherzelle sind in den Ansprüchen 9 bis 13 angegeben.

Die gleichzeitig eingereichte europäische Patentanmeldung 80 103 197.2 (Veröffentlichungsnummer 0 021 217) bezieht sich auf eine dynamische Halbleiter-Speicherzelle mit einem Speicherkondensator und einem Auswahlelement, das nicht aus einem Feldeffekttransistor besteht, sondern aus einem mit einer Bitleitung verbundenen Gebiet, das entgegengesetzt zu dem die Speicherzelle enthaltenden Halbleiterkörper dotiert ist, und aus einem mit einer Wortleitung verbundenen Transfergate, das isoliert über einem Teil der Grenzfläche des Halbleiterkörpers angeordnet ist, wobei dieser Teil an das genannte Gebiet und an den Halbleiterbereich des Speicherkondensators unmittelbar angrenzt.

Die Erfindung wird nachfolgend an Hand der Zeichnung näher erläutert. Dabei zeigt:

Fig. 1 einen Querschnitt durch ein Ausführungsbeispiel der Erfindung und

Fig. 2 eine Teilstruktur von Fig. 1, die im Verlauf eines bevorzugten Herstellungsverfahrens entsteht.

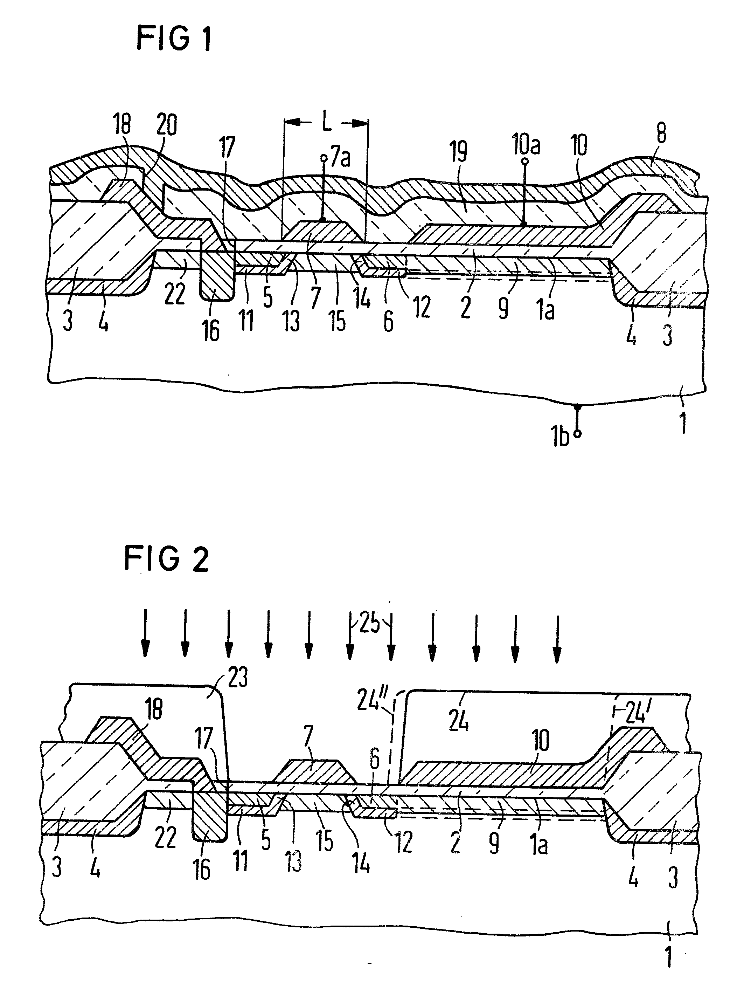

In Fig. 1 ist ein Körper aus einem halbleitenden Material, z. B. aus p-dotiertem Silizium, mit 1 bezeichnet. Seine Grenzfläche 1a ist mit einer elektrisch isolierenden Schicht bedeckt, die einen Bereich 2 mit kleinerer Schichtdicke aufweist. Für den Fall, dass es sich bei der isolierenden Schicht um $SiO_2$ handelt, wird der Bereich 2 auch als Gateoxidschicht bezeichnet. An den Bereich 2 schliessen sich Bereiche 3 der elektrisch isolierenden Schicht an, die mit einer wesentlich grösseren Schichtdicke ausgeführt sind und die im betrachteten Fall auch als Feldoxidschichten bezeichnet werden. Unterhalb der Feldoxidschichten 3 sind Halbleiterbereiche 4 vorgesehen, die $p^+$-dotiert sind und den Bereich der Speicherzelle zwischen sich einschliessen.

Zwei der Grenzfläche 1a benachbarte, $n^+$-dotierte Gebiete 5 und 6 sowie ein auf der Gateoxidschicht 2 angeordnetes Gate 7 sind Bestandteile eines Feldeffekttransistors, der das Auswahlelement der Speicherzelle darstellt. Dabei ist das Gebiet 5 in einer noch näher zu beschreibenden Weise mit einer Bitleitung 8 verbunden, über die eine zu speichernde binäre Information in die Speicherzelle eingeschrieben bzw. aus ihr ausgelesen wird. Das Gebiet 6 ist mit einer n-dotierten, der Grenzfläche 1a benachbarten Zone 9 des Halbleiterkörpers 1 verbunden, die die eine Elektrode eines Speicherkondensators darstellt und sich bis zu der durch das Gebiet 4 gegebenen lateralen Grenze der Speicherzelle hin erstreckt.

Die zweite Elektrode des Speicherkondensators wird durch eine elektrisch leitende Belegung 10 gebildet, die auf der Gateoxidschicht 2 und teilweise auf der Feldoxidschicht 3 angeordnet ist. Das Gate 7 ist mit einer Wortleitung verbunden, über die die Speicherzelle selektiert werden kann, während die Elektrode 10 mit einer festen Spannung beschaltet ist. Insbesondere bestehen das Gate 7 und die Elektrode 10 aus Teilen von streifenförmig ausgebildeten, in Fig. 1 senkrecht zur Bildebene verlaufenden, elektrisch leitenden Belegungen, die einer Gruppe von hintereinander liegenden Speicherzellen gemeinsam sind. Mit besonderem Vorteil sind das Gate 7 und die Elektrode 10 aus hochdotiertem, polykristallinem Silizium gebildet.

Unterhalb der Gebiete 5 und 6 befinden sich bezüglich der Grunddotierung des Halbleiterkörpers 1 gleichsinnig dotierte, jedoch einen höheren Dotierungsgrad aufweisende, d.h. $p^+$-dotierte Zonen 11 und 12, die den Gebieten 5 und 6 benachbart sind. Unterhalb des Gate 7 liegende Randbereiche 13, 14 dieser Zone erstrecken sich bis zur Grenzfläche 1a hin, so dass sie die Gebiete 5, 6 in lateraler Richtung begrenzen. Unterhalb des Gate 7 befindet sich ferner ein der Grenzfläche 1a benachbarter, die Randbereiche 13 und 14 miteinander verbindender n-dotierter Bereich 15. Legt man an das Gate 7 über einen Anschluss 7a eine die Einsatzspannung des Feldeffekttransistors übersteigende Spannung an, so bilden sich in den der Grenzfläche 1a anliegenden Teilen der Randbereiche 13 und 14 Inversionsschichten aus, die einen zweiteiligen Kanalbereich des Feldeffekttransistors darstellen.

Mit dem Gebiet 5 ist ein zusätzliches, n-dotiertes Gebiet 16 verbunden, das sich bis zur Grenzfläche 1a hin erstreckt. Die Gateoxidschicht 2 weist im Bereich des zusätzlichen Gebietes 16 ein Kontaktloch 17 auf, in dem eine elektrisch leitende Belegung 18, die teilweise oberhalb der Feldoxidschicht 3 angeordnet ist, das zusätzliche Gebiet 16 kontaktiert. Eine die Teile 7, 10 und 18 abdeckende, weitere Isolierschicht 19, die vorzugsweise ebenfalls aus SiO₂ besteht, weist oberhalb der Belegung 18 ein Kontaktloch 20 auf, in dem eine als metallische Leiterbahn ausgeführte, auf der Isolierschicht 19 verlegte Bitleitung 8 die Belegung 18 ihrerseits kontaktiert.

Das Gate 7 wird zweckmässigerweise so ausgeführt, dass es eine Länge L besitzt, die einem technologisch bedingten Mindestmass von beispielsweise 1 µm entspricht. Jeder innerhalb der Randgebiete 13 bzw. 14 liegende Teil des Transistorkanals weist dann eine Länge auf, die nur einem Bruchteil dieses Masses entspricht, also z.B. 0,2 bis 0,3 µm. Derartige laterale Abmessungen bringen es mit sich, dass der für den Feldeffekttransistor erforderliche Bedarf an Halbleiterfläche extrem klein gehalten werden kann. Anderseits wird hierdurch auch eine weitgehende Unabhängigkeit der Einsatzspannung des Feldeffekttransistors von Schwankungen einer über einen Anschluss 1b angelegten, negativen Substratvorspannung erreicht. An der Grenzfläche zwischen dem Gebiet 6 und der Zone 12 besteht eine Sperrschichtkapazität, die dem aus den Teilen 9 und 10 gebildeten Speicherkondensator parallel geschaltet ist und somit die Speicherkapazität der gesamten Zelle vergrössert.

Im Betrieb wird zum Einschreiben einer binären Information in die Speicherzelle so vorgegangen, dass das Gate 7 bzw. die mit diesem verbundene Wortleitung über den Anschluss 7a mit einer über der Einsatzspannung des Feldeffekttransistors liegenden Gatespannung beschaltet wird. Dadurch invertieren die an der Grenzfläche 1a liegenden Teile der Randgebiete 13 und 14, so dass zwei durch das Gebiet 15 miteinander verbundene, n-leitende Kanalteile entstehen. Dies ergibt eine leitende Verbindung zwischen dem mit der Bitleitung 8 in Verbindung stehenden Gebiet 5 und dem mit der Zone 9 in Verbindung stehenden Gebiet 6. Je nach der einzuschreibenden binären Information liegt die Bitleitung 8 auf einem niedrigen oder hohen positiven Potential, während die Elektrode 10 über einen Anschluss 10a an ein konstantes positives Potential gelegt ist. Bei einer auf niedrigem Potential liegenden Bitleitung 21 gelangen dann Ladungsträger aus dem Gebiet 5 in den aus den Teilen 9, 10 sowie 6, 12 gebildeten Speicherkondensator und laden diesen entsprechend auf. Legt man dann beim Auslesen der gespeicherten Information ein hohes Potential an die Bitleitung 8 und schaltet diese dann von äusseren Potentialen frei, d.h. bringt sie in einen Zustand, der mit «floating» bezeichnet wird, so fliesst die Ladung bei leitendem Transistorkanal 13, 14 wieder zurück und erzeugt einen Potentialabfall auf der Bitleitung 8, der von einer an diese geschalteten Leseeinrichtung ausgewertet wird. Dieses Lesesignal ist um so grösser, je kleiner die Kapazität der Bitleitung 8 gegenüber dem auf der Vorspannung befindlichen Substrat 1 ist. Bei der in Fig. 1 gezeigten Ausführung der Speicherzelle, bei der die Bitleitung 8 über die leitende Belegung 18 und das zusätzliche Gebiet 16 mit dem Gebiet 5 des Feldeffekttransistors verbunden ist, ergibt sich eine sehr kleine Bitleitungskapazität.

Nach der anderen Ausführungsform der Erfindung kann das zusätzliche Gebiet 16 in Fig. 1 einen Teil eines streifenförmigen Halbleitergebietes darstellen, das gleichzeitig die Bitleitung bildet. In diesem Fall kann die Leitung 8 als Wortleitung angesehen werden, die dann in einem nicht dargestellten Kontaktloch der isolierenden Schicht 19 das Gate 7 kontaktiert. Bei dieser Ausführungsform ist jedoch die Bitleitungskapazität grösser als bei der Ausführung nach Fig. 1, so dass das Auslesesignal der Speicherzelle kleiner ist.

Bei einer weiteren Ausführungsform der erfindungsgemässen Speicherzelle kann die leitende Belegung 18, die das zusätzliche Gebiet 16 kontaktiert, aus einem Teil einer streifenförmigen, leitenden Belegung bestehen, die selbst als Bitleitung dient. Eine solche Ausführungsform, bei der wieder die Leitung 8 als eine das Gate 7 kontaktierende Wortleitung aufzufassen ist, liegt sowohl bezüglich des strukturellen Aufwandes als auch bezüglich der Grösse des Auslesesignals zwischen den beiden vorher beschriebenen Ausführungsformen.

## Nach einer bevorzugten Weiterbildung der Erfindung sind das in Fig. 1 dargestellte Gebiet 6 sowie die unterhalb desselben liegende Zone 12 in lateraler Richtung so weit vergrössert, dass sie bis an die durch das stark dotierte Gebiet 4 gegebene Grenze reichen. Die vertikalen Grenzen der insoweit verlängerten Teile 6 und 12 sind in Fig. 1 gestrichelt eingezeichnet, wobei die in Fig. 1 durch eine ausgezogene Linie angedeutete Grenzfläche zwischen den Teilen 1 und 9 in diesem Fall entfällt. Hierbei ergibt sich eine wesentlich grössere Sperrschichtkapazität zwischen den Teilen 6 und 12, durch die die Speicherkapazität der Zelle wesentlich erhöht wird. Das bedeutet eine Vergrösserung des Auslesesignals bei gleichem Aufwand an Halbleiterfläche oder die Erzielung eines gleichen Auslesesignals mit einem wesentlich geringeren Flächenaufwand.

In Fig. 1 ist linksseitig vom Gebiet 16 ein n-dotiertes Gebiet 22 angedeutet, das einen Teil einer den gesamten Zellenbereich zwischen den dotierten Gebieten 4 umfassenden, der Grenzfläche 1a anliegenden Dotierungszone darstellt, wobei das Gebiet 15 und die Zone 9 als weitere Teile dieser Dotierungszone aufzufassen sind. Im Verlauf des Herstellungsprozesses entstehen aus dieser Dotierungszone durch das Einfügen der Gebiete 5, 6, 11, 12, 13, 14 und 16 die voneinander getrennten Teile 15, 9 und 22.

Bei der Herstellung der erfindungsgemässen Speicherzelle wird vorzugsweise so vorgegangen, dass zunächst der p-dotierte Halbleiterkörper 1 an seiner Grenzfläche 1a mit einem den Zellenbereich einschliessenden $p^+$-dotierten Gebiet 4 versehen wird. Anschliessend wird diese Grenzfläche mit einer elektrisch isolierenden Schicht abgedeckt, die ausserhalb des Zellenbereiches zu Dickschichtbereichen 3 anwächst, während sie innerhalb des Zellenbereiches einen Dünnschichtbereich 2 bildet. Anschliessend wird eine der Grenzschicht 1a anliegende, n-leitende Dotierungszone vorgesehen, die in lateraler Richtung von den Gebieten 4 begrenzt wird. Einzelne Teile dieser Dotierungszone sind in Fig. 2 mit den Bezugszeichen 22, 15 und 9 versehen. Es folgt ein Maskierungsschritt, der die Lage des zusätzlichen n-leitenden Gebietes 16 definiert, und ein dieses Gebiet erzeugender Diffusions- oder Implantationsvorgang. Anschliessend wird ein Kontaktloch 17 im Dünnschichtbereich 2 vorgesehen und eine Belegung der isolierenden Schicht 2, 3 mit einer Schicht aus hochdotiertem polykristallinem Silizium vorgenommen. Aus dieser Schicht werden mit Hilfe an sich bekannter fotolithografischer Schritte die Strukturen 18, 7 und 10 definiert. Dabei wird beim Entfernen der überflüssigen Schichtteile vorzugsweise ein Plasmaätzverfahren verwendet, wie es beispielsweise von Bell in den Proceedings of the International Conference on Microlithography, Paris 1977, Seiten 339–342, beschrieben wird, um abgeschrägte Kanten der bestehenbleibenden Strukturen zu erhalten, wie in Fig. 2 dargestellt ist. Die Struktur 18 stellt sodann eine das Gebiet 16 kontaktierende Belegung dar, die Struktur 7 bildet das Gate des Feldeffekttransistors und die Struktur 10 die äussere Elektrode des Speicherkondensators.

In einem weiteren Verfahrensschritt wird eine beispielsweise aus Fotolack bestehende Maske 23, 24 gebildet, die gemäss Fig. 2 den Zellenbereich etwa vom rechten Rand des Kontaktloches 17 bis zu der linken abgeschrägten Kante der Elektrode 10 freilässt. Mittels einer ersten Ionenimplantation, die durch die Pfeile 25 angedeutet ist, werden nun Ionen eines eine positive Leitfähigkeit bewirkenden Dotierungsstoffes mit einer solchen Energie eingebracht, dass in den Halbleiterbereichen, die lediglich von der dünnen Isolierschicht 2 bedeckt sind, tief liegende $p^+$-dotierte Gebiete 11 und 12 entstehen. Die abgeschrägten Kanten des Gate 7 bewirken dabei, dass unter ihnen Randbereiche 13 und 14 dieser Gebiete entstehen, die bis an die Grenzfläche 1a reichen. Es schliesst sich eine zweite Ionenimplantation an, bei der Ionen von Dotierungsstoffen, die eine negative Leitfähigkeit im Halbleiterkörper 1 hervorrufen, in Richtung der Pfeile 25 eingebracht werden. Hierbei wird jedoch eine geringere Beschleunigungsenergie aufgewandt, so dass die an der Grenzfläche 1a liegenden $n^+$-dotierten Gebiete 5 und 6 entstehen. Die von der Maske 23, 24 bedeckten Teile des Halbleiterkörpers 1 werden von den genannten Ionenimplantationen nicht beeinflusst. Ebenso der unterhalb des Gate 7 liegende Halbleiterbereich, wenn man von den abgeschrägten Randzonen des Gate absieht.

Bildet man den Maskenteil 24 so aus, dass er eine Kante 24' aufweist, die etwa mit dem Rand des Dickschichtbereiches 3 zusammenfällt, und führt die Implantationsvorgänge in der vorstehend beschriebenen Weise durch, wobei die Elektrode 10 erst nach den Implantationen mittels an sich bekannter fotolithografischer Verfahrensschritte aufgebracht wird, so ergeben sich Gebiete 6 und 12, die bis an den Maskenrand 24' verlängert sind, was in Fig. 2 gestrichelt angedeutet ist.

Nach dem Entfernen der Maske 23, 24 wird dann die vorhandene Zellenstruktur mit der elektrisch isolierenden Schicht 19 abgedeckt, auf der nach dem Anbringen des Kontaktloches 20 die Bitleitung 8 verlegt wird, die z.B. aus einer Aluminiumbahn besteht.

Zur weiteren Erläuterung der Erfindung kann das folgende Dotierungsbeispiel dienen, bei dem von einem mit $5 \cdot 10^{14}$ cm$^{-3}$ Akzeptoren, z.B. Bor-Atomen, dotierten Siliziumkörper 1 ausgegangen wird. Die Gebiete 4 weisen eine Dosis von 5 bis $10 \cdot 10^{11}$ cm$^{-2}$ Akzeptoren auf, die Gebiete 22, 15 und 9 sind mit Donatoren, z.B. Phosphor-Atomen, dotiert, und zwar mit einer Dosis von 5 bis $10 \cdot 10^{11}$ cm$^{-2}$. Die Dotierung des Gebietes 16 und der Gebiete 5 und 6 erfolgt etwa mit einer Dosis von 1 bis $10 \cdot 10^{14}$ cm$^{-2}$ Donatoren, z.B. Arsen-Atomen, während die Zonen 11, 13 und 12, 14 mit einer Dosis von 2 bis $3 \cdot 10^{12}$ cm$^{-2}$ Akzeptoren, z.B. Bor-Atomen, dotiert sind. Zum Implantieren der die Zonen 11, 13 und 12, 14 erzeugenden Akzeptorionen wird eine Beschleunigungsenergie von etwa 150 kEV verwendet, zum Einbringen der die Gebiete 5 und 6 erzeugenden Donatorionen eine solche von etwa 140 kEV.

Letztere Angaben beziehen sich auf ein Ausführungsbeispiel, bei dem die Gebiete 5 und 6 jeweils eine senkrecht zur Grenzfläche 1a gemessene Dicke von 0,1 μm aufweisen, während die Zonen 11 und 12 mit einer Dicke von 0,3 μm ausgeführt sind. Was die weiteren Strukturabmessungen anbetrifft, so beträgt die Dicke der Teile 7, 10 und 18 etwa 0,4 bis 0,7 μm und die Dicke der Schicht 2 etwa 50 nm. Die isolierende Schicht 19 weist eine Dicke von etwa 1 μm auf.

Bei einem anderen vorteilhaften Verfahren zur Herstellung der erfindungsgemässen Speicherzelle werden die Gebiete 5 und 6 sowie die Zonen 11 bis 14 nicht durch Implantationsschritte, sondern durch Diffusionsschritte erzeugt. Hierbei können die Kanten des Gate 7 auch in vertikaler Richtung verlaufen. Dieses Verfahren eignet sich besonders zur Herstellung einer Speicherzelle, bei der sich das Gebiet 6 und die Zone 12 auch auf den Bereich des Speicherkondensators erstrekken. Der Maskenteil 24 besitzt dann wieder die vordere Kante 24', während die Elektrode 10 erst nach den Diffusionsvorgängen mittels an sich bekannter fotolithografischer Schritte aufgebracht wird. Eine erste Diffusion von Akzeptor-Atomen erzeugt die Zonen 11 bis 14, während eine nachfolgende Diffusion mit Donator-Atomen die Gebiete 5 und 6 erzeugt. Die Dicke der Zonen 11 bis 14 wird durch unterschiedliche Diffusionszeiten bei beiden Diffusionsvorgängen eingestellt, was an sich aus der DMOS-Technologie bekannt ist.

Wendet man das letztere Verfahren zur Herstellung von erfindungsgemässen Speicherzellen an, bei denen sich das Gebiet 6 und die Zone 12 nicht auf den Speicherbereich erstrecken, so wird die Elektrode 10 vor den Diffusionsvorgängen aufgebracht. Damit jedoch die Zone 12 nicht an der Grenze zur Zone 9 einen zweiten, sich bis zur Grenzfläche 1a hin erstreckenden Randbereich erhält, was die Funktion der Speicherzelle stören würde, ist es notwendig, die erste Diffusion mit Akzeptor-Atomen mit einer Maske 24 vorzunehmen, die eine vordere Kante 24'' aufweist. Die zweite Diffusion mit Donator-Atomen erfolgt dann mit einer Maske 24, deren vordere Kante in Fig. 2 durch eine ununterbrochene Linie dargestellt ist.

Die Speicherzelle nach der Erfindung kann selbstverständlich auch auf einem n-dotierten Siliziumkörper 1 aufgebaut werden, wobei die Dotierungen derart abgeändert werden, dass sich jeweils die entgegengesetzten Leitfähigkeiten zu den bisher beschriebenen ergeben. In diesem Fall werden der Bitleitung 8 und den Anschlüssen 7a und 10a negative Spannungen zugeführt, während an dem Anschluss 1b eine positive Vorspannung liegt.

**Patentansprüche**

1. Dynamische Halbleiter-Speicherzelle mit einem Feldeffekttransistor, der ein isoliert auf der Grenzfläche eines Halbleiterkörpers aufgebrachtes Gate und zwei bezüglich einer Grunddotierung des Halbleiterkörpers entgegengesetzt dotierte Gebiete aufweist, und mit einem Speicherkondensator, der eine ebenfalls entgegengesetzt dotierte, der Grenzfläche benachbarte erste Zone des Halbleiterkörpers und eine isoliert auf der Grenzfläche aufgebrachte Elektrode aufweist, bei der das eine Gebiet mit einer Bitleitung und das andere mit der ersten Zone verbunden ist, dadurch gekennzeichnet, dass im wesentlichen parallel zu der Grenzfläche (1a) verlaufende, bezüglich der Grunddotierung gleichsinnig dotierte, jedoch einen höheren Dotierungsgrad aufweisende, weitere Zonen (11, 12) vorgesehen sind, die unterhalb der genannten Gebiete (5, 6) liegen und an diese angrenzen, dass sich unterhalb des Gate (7) liegende Randbereiche (13, 14) der weiteren Zonen (11, 12) bis zur Grenzfläche (1a) hin erstrecken, so dass sie die Gebiete (5, 6) in lateraler Richtung begrenzen, dass unterhalb des Gate (7) ein der Grenzfläche (1a) benachbarter, die genannten Randbereiche (13, 14) verbindender Bereich (15) des Halbleiterkörpers (1) mit einer zu der Grunddotierung entgegengesetzten Dotierung versehen ist und dass die an der Grenzfläche (1a) liegenden Teile der Randbereiche (13, 14) einen zweiteiligen Kanalbereich des Feldeffekttransistors bilden.

2. Halbleiter-Speicherzelle nach Anspruch 1, dadurch gekennzeichnet, dass das über den Kanalbereich mit der Bitleitung (8) verbindbare Gebiet (6) und die unter diesem liegende, weitere Zone (12) in lateraler Richtung so bemessen sind, dass sie sich auch auf den Bereich des Speicherkondensators erstrecken.

3. Halbleiter-Speicherzelle nach Anspruch 1 oder 2, dadurch gekennzeichnet, dass das mit der Bitleitung (8) verbundene Gebiet (5) mit einem zusätzlichen, bezüglich der Grunddotierung entgegengesetzt dotierten Gebiet (16) verbunden ist.

4. Halbleiter-Speicherzelle nach Anspruch 3, dadurch gekennzeichnet, dass das zusätzliche, entgegengesetzt dotierte Gebiet (16) mit einer in dem Halbleiterkörper (1) vorgesehenen, entgegengesetzt dotierten, streifenförmigen Halbleiterzone verbunden ist, die als Bitleitung dient.

5. Halbleiter-Speicherzelle nach Anspruch 3, dadurch gekennzeichnet, dass das zusätzliche, entgegengesetzt dotierte Halbleitergebiet (16) im Bereich eines Kontaktloches (17) der elektrisch isolierenden Schicht (2) mit einer elektrisch leitenden Belegung (18) kontaktiert ist, die ihrerseits mit einer Bitleitung verbunden ist.

6. Halbleiter-Speicherzelle nach Anspruch 5, dadurch gekennzeichnet, dass die Bitleitung als eine metallische Leiterbahn (8) ausgeführt ist, die auf einer die Halbleiter-Speicherzelle abdeckenden Isolierschicht (19) verlegt ist und im Bereich eines weiteren Kontaktloches (20) die elektrisch leitende Belegung (18) kontaktiert.

7. Halbleiter-Speicherzelle nach einem der vorhergehenden Ansprüche, dadurch gekennzeichnet, dass der Halbleiterkörper (1) mit einem an einer festen Spannung liegenden Anschluss (1b) versehen ist und dass die Elektrode (10) des Speicherkondensators über einen Anschluss (10a) mit einem vorgegebenen Potential beschaltet ist.

8. Halbleiter-Speicherzelle nach einem der vorhergehenden Ansprüche, dadurch gekennzeichnet, dass der Halbleiterkörper (1) aus dotiertem Silizium besteht und dass das Gate (7) und/oder die Elektrode (10) des Speicherkondensators und/oder die das zusätzliche Gebiet (16) kontaktierende Belegung (18) aus hochdotiertem, polykristallinem Silizium gebildet sind.

9. Verfahren zur Herstellung einer Halbleiter-Speicherzelle nach Anspruch 1, dadurch gekennzeichnet, dass ein mit einer Grunddotierung versehener Halbleiterkörper an seiner Grenzfläche mit einer elektrisch isolierenden Schicht abgedeckt wird, die einen Dünnschichtbereich und einen diesen umgebenden Dickschichtbereich aufweist, dass der Halbleiterkörper an der Grenzfläche unterhalb des Dünnschichtbereiches mit einer Dotierungszone versehen wird, die eine zu der Grunddotierung entgegengesetzte Dotierung aufweist, dass in dem Dünnschichtbereich eine Öffnung vorgesehen wird, unter der das zusätzliche Gebiet erzeugt wird, das eine zur Grunddotierung entgegengesetzte Dotierung besitzt, dass auf der isolierenden Schicht ein Gate und die Elektrode des Speicherkondensators plaziert werden, dass eine erste Maske vorgesehen wird, die lediglich das Gate und zwei diesem benachbarte, als Source- und Drain-Gebiete des Feldeffekttransistors dienende Gebiete im wesentlichen unbedeckt lässt, dass ein erster Dotierungsschritt mit einem der Grunddotierung entsprechenden Dotierstoff vorgenommen wird, der die unterhalb der letztgenannten Gebiete liegenden weiteren Zonen erzeugt, und dass zur Bildung dieser Gebiete ein zweiter Dotierungsschritt mit einem Dotierstoff erfolgt, der eine zu der Grunddotierung entgegengesetzte Dotierung erzeugt, wobei der zweite Dotierungsschritt auf den ersten so abgestimmt wird, dass die weiteren Zonen unterhalb des Gate Randbereiche aufweisen, die sich bis zur Grenzfläche erstrecken und die genannten Gebiete in lateraler Richtung begrenzen.

10. Verfahren nach Anspruch 9, dadurch gekennzeichnet, dass neben dem Gate und der Elektrode auch eine das zusätzliche Gebiet kontaktierende Belegung auf der elektrisch isolierenden Schicht plaziert wird, dass die nach den beiden Dotierungsschritten entstandene Teilstruktur mit einer weiteren, elektrisch isolierenden Schicht abgedeckt wird und dass auf der letzteren eine Leiterbahn verlegt wird, die die kontaktierende Belegung innerhalb eines in der weiteren elektrisch isolierenden Schicht vorgesehenen Kontaktloches ihrerseits kontaktiert.

11. Verfahren zur Herstellung einer Halbleiter-Speicherzelle nach Anspruch 2, dadurch gekennzeichnet, dass ein mit einer Grunddotierung versehener Halbleiterkörper an seiner Grenzfläche mit einer elektrisch isolierenden Schicht abgedeckt wird, die einen Dünnschichtbereich und einen diesen umgebenden Dickschichtbereich aufweist, dass der Halbleiterkörper an der Grenzfläche unterhalb des Dünnschichtbereiches mit einer Dotierungszone versehen wird, die eine zu der Grunddotierung entgegengesetzte Dotierung aufweist, dass in dem Dünnschichtbereich eine Öffnung vorgesehen wird, unter der das zusätzliche Gebiet erzeugt wird, das eine zur Grunddotierung entgegengesetzte Dotierung besitzt, dass auf der isolierenden Schicht ein Gate plaziert wird, dass eine zweite Maske vorgesehen wird, die das Gate, zwei demselben benachbarte, als Source- und Draingebiete des Feldeffekttransistors dienende Gebiete und den Bereich des Speicherkondensators unbedeckt lässt, dass ein erster Dotierungsschritt mit einem der Grunddotierung entsprechenden Dotierstoff vorgenommen wird, der die unterhalb der letztgenannten Gebiete liegenden weiteren Zonen erzeugt, von denen sich eine auf den Bereich des Speicherkondensators erstreckt, dass ein zweiter Dotierungsschritt mit einem Dotierstoff erfolgt, der eine zu der Grunddotierung entgegengesetzte Dotierung erzeugt und die als Source- und Draingebiete des Feldeffekttransistors dienenden Gebiete bildet, von denen sich das eine auf den Bereich des Speicherkondensators erstreckt, dass anschliessend die zweite Maske entfernt wird und dass die Elektrode des Speicherkondensators auf der elektrisch isolierenden Schicht plaziert wird.

12. Verfahren nach einem der Ansprüche 9 oder 11, dadurch gekennzeichnet, dass das Gate mit abgeschrägten Kanten ausgebildet wird und dass die beiden Dotierungsschritte aus Ionenimplantationsschritten bestehen.

13. Verfahren nach Anspruch 9, dadurch gekennzeichnet, dass die beiden Dotierungsschritte aus Diffusionsschritten bestehen und dass die erste Maske für den ersten Diffusionsschritt so ausgebildet wird, dass ihre Kante auch einen dem Speicherkondensator zugewandten Randstreifen des einen Gebietes mitbedeckt, während sie für den zweiten Diffusionsschritt mit einer hiergegen verschobenen Kante ausgebildet wird, die diesen Randstreifen unbedeckt lässt.

14. Verfahren nach Anspruch 11, dadurch gekennzeichnet, dass die beiden Dotierungsschritte aus Diffusionsschritten bestehen.

**Claims**

1. A dynamic semiconductor storage cell comprising a field effect transistor provided with a gate applied in insulated manner to the boundary surface of a semiconductor body, and having two regions which are oppositely doped with respect to a basic doping, said storage cell also comprising a storage capacitor which comprises a first zone of the semiconductor body which is likewise oppositely doped and adjoins the boundary surface, and an electrode which is applied to the boundary surface in insulated manner, one of said regions being connected to a bit line and the other of said regions to said first zone, characterised in that there are provided further zones (11, 12) which run essentially parallel to the boundary surface (1a), have the same doping as the basic doping but have a higher doping level, and are arranged below and adjoin said regions (5, 6) that edge regions (13, 14) of the further zones (11, 12), which are arranged below the gate (7), extend to the boundary surface (1a) so that they laterally delimit the regions (5, 6); that below the gate (7), there is arranged a region (15) of the semiconductor body (1), which region adjoins the boundary surface (1a) and connects said edge regions (13, 14), and is provided with a doping which is opposite to the basic doping; and that the parts of the edge regions (13, 14) which lie in the boundary surface (1a) form a two-part channel region of the field effect transistor.

2. A semiconductor storage cell as claimed in Claim 1, characterised in that the region (6) which can be connected by way of the channel region to the bit line (8), and the further zone (12) which lies beneath said region are laterally so dimensioned that they also extend to the vicinity of the storage capacitor.

3. A semiconductor storage cell as claimed in Claim 1 or Claim 2, characterised in that the region (5) which is connected to the bit line (8), is connected to an additional region (16) which is oppositely doped to the basic doping.

4. A semiconductor storage cell as claimed in Claim 3, characterised in that the additional oppositely-doped region (16) is connected to an oppositely-doped, strip-shaped semiconductor zone arranged in the semiconductor body (1), which serves as a bit line.

5. A semiconductor storage cell as claimed in Claim 3, characterised in that the additional, oppositely-doped semiconductor region (16) is contacted in the region of a contact hole (17) in the electrically-insulating layer (2) with an electrically-conductive coating (18) which is in turn connected to a bit line.

6. A semiconductor storage cell as claimed in Claim 5, characterised in that the bit line is in the form of a metal conductor path (8) which runs on an insulating layer (19) covering the semiconductor storage cell and which contacts the electrically-conductive coating (18) in the region of a further contact hole (20).

7. A semiconductor storage cell as claimed in one of the preceding Claims, characterised in that the semiconductor body (1) is provided with a terminal (1b) connected to a fixed voltage; and that the electrode (10) of the storage capacitor is connected to a predetermined potential by means of a terminal (10a).

8. A semiconductor storage cell as claimed in one of the preceding Claims, characterised in that the semiconductor body (1) consists of doped silicon, and that the gate (7) and/or the electrode (10) of the storage capacitor and/or the coating (18) which contacts the additional region (16), is or are formed from highly-doped, polycrystalline silicon.

9. A process for the production of a semiconductor storage cell as claimed in Claim 1, characterised in that, at its boundary surface, a semiconductor body having a basic doping is covered with an electrically-insulating layer which has a thin layer region and a thick layer region surrounding the former that at the boundary surface below the thin layer region, the semiconductor body is provided with a doped zone having a doping which is opposite to the basic doping; that the thin layer region is provided with an opening, underneath which the additional region, which has a doping opposite to the basic doping, is produced; that a gate and the electrode of the storage capacitor are positioned on the insulating layer; that there is provided a first mask which essentially leaves uncovered only the gate and two regions which are adjacent thereto and which serve as the source and drain zones of the field effect transistor; that a first doping step is carried out using a dopant corresponding to the basic doping, which doping step produces the further zones which are arranged below the lastmentioned regions; and that, in order to form these regions, a second doping step is carried out using a dopant which produces a doping which is opposite to the basic doping, the second doping step being so matched with the second doping step that, below the gate, the further zones have edge regions which extend to the boundary surface and which laterally delimit said regions.

10. A process as claimed in Claim 9, characterised in that, in addition to the gate and the electrode, a coating contacting the additional region is positioned on the electrically-insulating layer; that the partial structure formed after the two doping steps is covered with a further electrically-insulating layer; and that a conductor path is laid on the latter, which conductor path in turn contacts the contacting coating within a contact hole which is provided in the further electrically-insulating layer.

11. A process for the production of a semiconductor storage cell as claimed in Claim 2, characterised in that, at its boundary surface, a semiconductor body having a basic doping is covered with an electrically-insulating layer which has a thin layer region and a thick layer region surrounding the former; that at the boundary surface below the thin layer region, the semiconductor body is provided with a doped zone having a doping which is opposite to the basic doping; that in the thin layer region, there is arranged an opening beneath which the additional region having a doping which is opposite to the basic doping is produced; that a gate is positioned on the insulating layer; that there is provided a second mask which leaves uncovered the gate, two regions which are adjacent thereto and serve as the source and drain zones of the field effect transistor, and the region of the storage capacitor; that a first doping step is carried out using a dopant corresponding to the basic doping; which doping step produces the further zones which lie beneath said regions serving as source and drain zones of the field effect transistor, and one of which extends to the region of the storage capacitor; that a second doping step is carried out using a dopant which produces a doping which is opposite to the basic doping and produces the regions which serve as source region and drain zones of the field effect transistor and of which one extends to the region of the storage capacitor; that the second mask is subsequently removed and that the electrode of the storage capacitor is positioned on the electrically-insulating layer.

12. A process as claimed in Claim 9 or Claim 11, characterised in that the gate is formed with chamfered edges and that the two doping steps are ion implantation steps.

13. A process as claimed in Claim 9, characterised in that the two doping steps are diffusion steps; and that the first mask for the first diffusion step is so designed that its edge also covers an edge strip of the one region, which edge strip faces towards the storage capacitor, whilst for the second diffusion step, it is provided with an edge which is displaced relative thereto and leaves the edge strip uncovered.

14. A process as claimed in Claim 11, characterised in that the two doping steps are diffusion steps.

## Revendications

1. Cellule de mémoire dynamique à semi-conducteurs, qui comporte un transistor à effet de champ, qui possède une porte disposée de façon isolée sur la surface limite d'un corps semi-conducteur et deux régions dopées de façon opposée par rapport au dopage de base du corps semi-conducteur, ainsi qu'un condensateur de mémorisation, qui comporte une première zone du corps semi-conducteur, qui est voisine de la surface limite et qui est également dopée de façon opposée, et une électrode disposée de façon isolée sur la surface limite, dans laquelle une des régions est reliée à une ligne de bits et l'autre est reliée à la première zone, caractérisée par le fait que sont prévues d'autres zones 11, 12, qui s'étendent sensiblement parallèlement à la surface limite (1a), sont dopées avec le même dopage que le dopage de base, mais avec un degré de dopage plus important, se trouvent sous lesdites régions (5, 6) et sont contiguës à celles-ci, que des domaines marginaux (13, 14) des autres zones (11, 12) qui se trouvent sous la porte (7) s'étendent jusqu'à la surface limite (1a) de sorte qu'ils délimitent les régions (5, 6) suivant la direction latérale, que sous la porte (7) est prévu un domaine (15) du corps semi-conducteur (1), qui possède un dopage opposé au dopage de base, qui relie lesdits domaines marginaux (13, 14) et qui est voisin de la surface limite (1a), et que les parties des domaines marginaux (13, 14) qui se trouvent au niveau de la surface limite (1a) forment un domaine de canal en deux parties du transistor à effet de champ.

2. Cellule de mémoire à semi-conducteurs suivant la revendication 1, caractérisée par le fait que la région (6), qui peut être reliée à la ligne de bits (8) par l'intermédiaire du domaine de canal, et l'autre zone (12), qui se trouve sous celle-ci, sont dimensionnés suivant la direction latérale de manière à s'étendre également sur le domaine du condensateur de mémorisation.

3. Cellule de mémoire à semi-conducteurs suivant l'une des revendications 1 ou 2, caractérisée par le fait que la région (5), qui est reliée à la ligne de bits (8), est reliée à une région supplémentaire (16) qui possède un dopage opposé au dopage de base.

4. Cellule de mémoire à semi-conducteurs suivant la revendication 3, caractérisée par le fait que la région supplémentaire (16), dopée de façon opposée, est reliée à une zone semi-conductrice en forme de bande, prévue dans le corps semi-conducteur (1) et dopée de façon opposée, qui sert de ligne de bits.

5. Cellule de mémoire à semi-conducteurs suivant la revendication 3, caractérisée par le fait que la région semi-conductrice supplémentaire (16), dopée de façon opposée, est mise en contact, dans la région d'un trou de contact (17) de la couche (2) isolante du point de vue électrique, avec un revêtement (18) conducteur du point de vue électrique qui, de son côté, est relié à une ligne de bits.

6. Cellule de mémoire à semi-conducteurs suivant la revendication 5, caractérisée par le fait que la ligne de bits est réalisée sous la forme d'une voie conductrice métallique (8), qui est située sur une couche isolante (19) recouvrant la cellule de mémoire à semi-conducteurs, et qui est en contact avec le revêtement (18) conducteur du point de vue électrique, dans la région d'un autre trou de contact (20).

7. Cellule de mémoire à semi-conducteurs suivant l'une des revendications précédentes, caractérisée par le fait que le corps semi-conducteur (1) est muni d'une borne (1b) qui est reliée à une tension fixe, et que l'électrode (10) du condensateur de mémorisation est reliée à un potentiel prédéterminé, par l'intermédiaire d'une borne (10a).

8. Cellule de mémoire à semi-conducteurs suivant l'une des revendications précédentes, caractérisée par le fait que le corps semi-conducteur (1) est constitué par du silicium dopé, et que la porte (7) et/ou l'électrode (10) du condensateur de mémorisation et/ou le revêtement (18) faisant contact avec la région supplémentaire (16), sont formés par du silicium polycristallin fortement dopé.

9. Procédé pour fabriquer une cellule de mémoire à semi-conducteurs suivant la revendication 1, caractérisé par le fait qu'un corps semi-conducteur possédant un dopage de base est recouvert, sur sa surface limite, d'une couche isolante du point de vue électrique, qui comporte un domaine de couche mince et un domaine de couche épaisse entourant celui-ci, que le corps semi-conducteur est muni, au niveau de la surface limite, sous le domaine de couche mince, d'une zone de dopage qui présente un dopage opposé au dopage de base, que dans la région de couche mince est prévue une ouverture sous laquelle est formée la région supplémentaire qui possède un dopage opposé au dopage de base, que sur la couche isolante sont placées une porte et l'électrode du condensateur de mémorisation, qu'il est prévu un premier masque qui laisse essentiellement à découvert simplement la porte et deux régions voisines de cette porte et servant de régions de source et de drain du transistor à effet de champ, qu'on effectue une première phase de dopage avec une substance dopante correspondant au dopage de base, qui produit les autres zones qui se trouvent sous les dernières régions citées, et que pour former ces régions on effectue une seconde phase de dopage avec une substance dopante qui produit un dopage opposé au dopage de base, la seconde phase de dopage étant réglée vis-à-vis de la première de manière que les autres zones sous la porte comportent des domaines marginaux qui s'étendent jusqu'à la surface limite et qui délimitent lesdites régions dans la direction latérale.

10. Procédé suivant la revendication 9, caractérisé par le fait qu'en plus de la porte et de l'électrode, un revêtement faisant contact avec la région supplémentaire est également placé sur la couche isolante du point de vue électrique, que la structure partielle obtenue après les deux phases de dopage est recouverte par une autre couche isolante du point de vue électrique, et que sur cette dernière est placée une voie conductrice qui, de son côté, fait contact avec le revêtement de contact à l'intérieur d'un trou de contact prévu dans l'autre couche isolante du point de vue électrique.

11. Procédé pour fabriquer une cellule de mémoire à semi-conducteurs suivant la revendication 2, caractérisé par le fait qu'un corps semi-conducteur possédant un dopage de base est recouvert, au niveau de sa surface limite, par une couche isolante du point de vue électrique, qui comporte un domaine de couche mince et un domaine de couche épaisse entourant celui-ci, que le corps semi-conducteur est muni, au niveau de la surface limite, sous la région de couche mince, d'une zone de dopage qui possède un dopage opposé au dopage de base, qu'il est prévu dans la région de couche mince une ouverture sous laquelle est formée la région supplémentaire qui possède un dopage opposé au dopage de base, qu'une porte est placée sur la couche isolante, qu'on prévoit un second masque, qui laisse à découvert la porte, deux régions voisines de celle-ci et servant de régions de source et de drain du transistor à effet de champ, et le domaine du condensateur de mémorisation, qu'on effectue une première phase de dopage avec une substance de dopage correspondant au dopage de base, qui produit les autres zones qui se trouvent sous les dernières régions citées, zones dont une s'étend sur le domaine du condensateur de mémorisation, qu'on effectue ensuite une seconde phase de dopage avec une substance de dopage qui produit un dopage opposé au dopage de base et forme les régions servant de régions de source et de drain du transistor à effet de champ, régions dont une s'étend sur le domaine du condensateur de mémorisation, qu'ensuite le second masque est enlevé, et que l'électrode du condensateur de mémorisation est placée sur la couche isolante du point de vue électrique.

12. Procédé suivant l'une des revendications 9 ou 11, caractérisé par le fait que la porte est réalisée avec des arêtes chanfreinées, et que les deux phases de dopage sont des phases d'implantation d'ions.

13. Procédé suivant la revendication 9, caractérisé par le fait que les deux phases de dopage sont constituées par des phases de diffusion, et que le premier masque pour la première phase de diffusion est agencé de manière que son bord recouvre également une bande marginale, tournée vers le condensateur de mémorisation, d'une des régions, tandis que pour la seconde phase de diffusion il est réalisé avec une arête décalée qui laisse à découvert cette bande marginale.

14. Procédé suivant la revendication 11, caractérisé par le fait que les deux phases de dopage sont constituées par des phases de diffusion.

# FIG 1

# FIG 2